# EUROPÄISCHE PATENTANMELDUNG

(11) **EP 2 073 620 A1**
(43) Veröffentlichungstag der Anmeldung: **24.06.2009**
(21) Anmeldenummer: 08166904.6
(22) Anmeldetag: 17.10.2008
(51) Int. Cl.: H05K 13/00, H05K 13/04

(54) **Substrat-Transportvorrichtung für einen Bestückautomaten**

(30) Priorität: 18.12.2007 DE 102007060855
(71) Anmelder: Siemens Aktiengesellschaft, 80333 München (DE)
(72) Erfinder: Dietrich, Stefan, 76149, Karlsruhe (DE); Fichtner-Pflaum, Gerolf, 76703, Kraichtal (DE); Liegel, Werner, 82538, Geretsried (DE); Schulz, Ralf, 81241, München (DE); Stützer, Roland, 589630, Singapore (SG); Zimmermann, Bernd, 76297, Stutensee/Blankenloch (DE)

(57) **Zusammenfassung**

Die erfindungsgemäße Transportvorrichtung (40) zum Transportieren von Substraten (22) in einen Bestückbereich (11) eines Bestückautomaten (10) zum Bestücken der Substrate (22) mit Bauelementen (23) weist mindestens ein erstes und ein zweites Spurenpaar (50, 60) auf, welche nebeneinander angeordnet sind, wobei jedes Spurenpaar (50, 60) aus zwei einzelnen, nebeneinander liegenden ersten und zweiten Transportspuren (51, 52, 61, 62) besteht. Mit Hilfe dieser Transportvorrichtung (40), deren Spurenpaare (50, 60) sowohl in einem synchronen als auch in einem asynchronen Modus betrieben werden können, kann der Bestückinhalt und damit die Bestückleistung des Bestückautomaten (10) deutlich erhöht werden.

## Beschreibung

Die Erfindung betrifft eine Transportvorrichtung zum Transportieren von Substraten in einen Bestückbereich eines Bestückautomaten zum dortigen Bestücken der Substrate mit Bauelementen.

Bei Bestückautomaten zum Bestücken von Substraten mit Bauelementen werden die Substrate über eine Transportstrecke mittels einer Transportvorrichtung in einen Bestückbereich des Bestückautomaten transportiert. Seitlich der Transportstrecke sind Zuführvorrichtungen zum Bereitstellen der Bauelemente angeordnet. Ein durch ein Positioniersystem verfahrbarer Bestückkopf des Bestückautomaten holt die Bauelemente von den Zuführvorrichtungen ab, verfährt sie in den Bestückbereich, in dem das zu bestückende Substrat bereitgestellt ist und setzt die Bauelemente auf dem Substrat ab.

In den letzten Jahren ging der Trend zu immer leistungsfähigeren Bestückautomaten, die immer mehr Bauelemente je Zeiteinheit verarbeiten können. Dabei kamen sowohl einspurige als auch mehrspurige Transportvorrichtungen zum Einsatz. Eine gängige Ausgestaltung ist der zweispurige Doppeltransport, bei dem zwei Transportspuren parallel nebeneinander angeordnet sind. Dabei können die beiden Spuren sowohl im synchronen als auch im asynchronen Modus betrieben werden. Der synchrone Modus hat den Vorteil, dass bei identisch zu bestückenden Substraten der Bestückinhalt, d. h. die Anzahl der im Bestückbereich zu bestückenden Bauelemente, verdoppelt wird, was zu einer Erhöhung der Bestückleistung führt, da die Wechselzeiten für die Substrate - relativ betrachtet - in Bezug auf die Bestückzeiten abnehmen. Der asynchrone Modus hat hingegen den Vorteil, dass die Leiterplatten-Wechselzeiten weitgehend eliminiert werden können, da immer ein Substrat bestückt werden kann, während das andere Substrat gerade in den Bestückbereich transportiert wird. Hierdurch kann ebenfalls die Bestückleistung erhöht werden.

Aus der US 2004/0128827 A1 ist eine zweispurige Substrat-Transportvorrichtung bekannt, welche sowohl im synchronen Modus als auch im asynchronen Modus betrieben werden kann.

Es ist die Aufgabe der vorliegenden Erfindung, eine Transportvorrichtung, einen Bestückautomaten, sowie ein Verfahren zum Bestücken von Substraten mit Bauelementen bereitzustellen, durch welche die Bestückleistung des Bestückautomaten deutlich erhöht werden kann.

Diese Aufgabe wird durch die Transportvorrichtung, dem Bestückautomaten sowie das Bestückverfahren gemäß den unabhängigen Ansprüchen gelöst. Vorteilhafte Ausgestaltungen sind Gegenstand der abhängigen Ansprüche.

Gemäß Anspruch 1 wird eine Transportvorrichtung zum Transportieren von Substraten in einen Bestückbereich eines Bestückautomaten zum Bestücken der Substrate mit Bauelementen beansprucht, wobei die Transportvorrichtung mindestens ein erstes und ein zweites Spurenpaar aufweist, welche nebeneinander angeordnet sind, wobei jedes Spurenpaar aus zwei einzelnen, nebeneinander liegenden ersten und zweiten Transportspuren besteht.

Durch die Verwendung einer Transporteinrichtung mit mehreren Transportspuren ergibt insbesondere bei kleinen Substraten der Vorteil, dass der Bestückinhalt deutlich erhöht werden kann. Unter dem Bestückinhalt ist dabei die Anzahl der Bauelemente verstehen, die auf ein Substrat zwischen zwei Substrat-Wechseln positioniert werden. Beispielsweise ist es bei einem synchronen Betriebsmodus der Transportspuren möglich, mehrere Substrate gleichzeitig im Bestückbereich des Bestückautomaten zu positionieren und zu bestücken. Der relative Anteil der Substrat-Wechselzeit an der gesamten Bearbeitungszeit kann dadurch reduziert werden. Der relative Anteil der Bestückzeit erhöht sich entsprechend. Die Bestückleistung des Bestückautomaten kann dadurch deutlich erhöht werden.

Bei der Bestückung von Substraten mit sehr kleinen Abmessungen ist es weiterhin möglich, der Transportvorrichtung ein weiteres Spurenpaar hinzuzufügen, um den Bestückinhalt weiter zu erhöhen. Die Anzahl der Transportspuren erhöht sich dabei jeweils um 2, so dass immer eine geradzahlige Anzahl an Transportspuren zur Verfügung steht.

In einer Ausgestaltung der Transportvorrichtung nach Anspruch 2 sind die beiden nebeneinander liegenden Transportspuren eines jeden Spurenpaars synchron antreibbar. Die mindestens zwei Spurenpaare können dabei entweder synchron oder sowohl synchron als auch asynchron betrieben werden.

Durch den synchronen Betrieb der beiden nebeneinander liegenden Transportspuren eines Spurenpaares können zwei Substrate gleichzeitig in den Bestückbereich des Bestückautomaten transportiert und dort bereitgestellt werden, wodurch sich der Bestückinhalt verdoppelt. Durch den synchronen Betrieb der mindestens zwei Spurenpaare werden gleichzeitig weitere Substrate im Bestückbereich bereitgestellt, so dass der Bestückinhalt weiter erhöht werden kann. die mindestens zwei Spurenpaare können auch asynchron betrieben werden. In diesem Fall befinden sich im Bestückbereich immer mindestens zwei Substrate eines Spurenpaares, während Substrate der anderen Spurenpaare gerade in den Bestückbereich transportiert werden. Hierdurch können die Substrat-Wechselzeiten weitestgehend eliminiert werden. Somit lassen sich mit Hilfe der Transportvorrichtung die Vorteile sowohl des synchronen als auch des asynchronen Betriebsmodus realisieren.

In einer Ausgestaltung der Transportvorrichtung nach Anspruch 3 sind die einzelnen Transportspuren auf die Breite der zu transportierenden Substrate individuell einstellbar.

Dadurch ist es möglich, die Transportvorrichtung sowohl für den Transport und die Bereitstellung identisch zu bestückende Substrate eines bestimmten Substrattyps als auch für Substrate unterschiedlicher Substrattypen einzusetzen. Die Flexibilität der Transportvorrichtung kann dadurch deutlich erhöht werden.

Gemäß Anspruch 4 wird ein Bestückautomat zum Bestücken von Substraten mit Bauelementen mit einer Transportvorrichtung nach einem der Ansprüche 1 bis 3 beansprucht.

Hinsichtlich der Vorteile, die ein derartiger Bestückautomat bietet, wird auf obige Ausführungen zu den Ansprüchen 1 bis 3 verwiesen.

In einer Ausgestaltung nach Anspruch 5 weist der Bestückautomat mehrere Bestückköpfe zum Bestücken der Substrate auf. Dabei ist jedem Bestückkopf eines der Spurenpaare eindeutig zugeordnet, so dass mittels dieses Bestückkopfes nur Substrate dieses einen Spurenpaares bestückbar sind.

Mittels der Transportvorrichtung können mehrere Substrate gleichzeitig in einem Bestückbereich des Bestückautomaten bereitgestellt werden. Durch die feste Zuordnung eines jeden Spurenpaares zu einem Bestückkopf, und damit einhergehend der festen Zuordnung der mittels dieses Spurenpaares bereitgestellten Substrate zu diesem Bestückkopf, wird sichergestellt, dass die Bestückköpfe räumlich unabhängig voneinander agieren können und sich nicht gegenseitig beeinflussen bzw. behindern.

In einer Ausgestaltung nach Anspruch 6 weist der Bestückautomat einen Querträger auf, welcher die Transportvorrichtung überspannt, sich dabei quer zu einer Transportrichtung der Substrate erstreckt und zum Anbringen mindestens eines Portalarmes dient. Weiterhin weist der Bestückautomat zwei Portalarme auf, welche sich in Transportrichtung der Substrate erstrecken und nebeneinander auf derselben Seite des Querträgers verschiebbar angeordnet sind. Ferner sind zwei Bestückköpfe vorgesehen, welche jeweils an einem der Portalarme angeordnet und einander zugewandt sind.

Vorzugsweise sind die beiden Portalarme zueinander parallel am Querträger angeordnet. Indem die Bestückköpfe zueinander orientiert sind, können sie bzgl. ihrer jeweiligen Bauelement-Absetzpositionen enger zueinander verfahren werden, ohne sich gegenseitig zu behindern. Dies ist insbesondere bei der Bestückung in den Randbereichen der Substrate von Vorteil: Hier besteht ansonsten die Gefahr, dass die Bestückköpfe bzw. die Portalarme miteinander kollidieren. Durch die spiegelbildliche Anordnung der Bestückköpfe können die Substrate auch in eng benachbarten Randbereichen gleichzeitig sicher bestückt werden.

Gemäß Anspruch 7 wird ein Verfahren zum Bestücken von Substraten mit Bauelementen mit einem Bestückautomaten nach einem der Ansprüche 4 bis 6 beansprucht. Die beiden Transportspuren des ersten Spurenpaares sowie die beiden Transportspuren des zweiten Spurenpaares werden dabei jeweils derart betrieben, dass mittels eines Spurenpaares zwei Substrate gleichzeitig im Bestückbereich bereitgestellt werden.

Durch einen derartigen Betrieb der beiden Transportspuren eines Spurenpaares ergibt sich der Vorteil, dass der Bestückinhalt dieses Spurenpaares, verglichen mit einer einspurigen Transportvorrichtung oder einem asynchron betriebenen Doppeltransport, verdoppelt werden kann. Dadurch kann der relative Zeitanteil des Substratwechsels bezogen auf die gesamte Bearbeitungsdauer deutlich reduziert werden. Weiterhin ergibt sich der Vorteil, dass für die beiden Transportspuren eines Spurenpaares nur ein Antrieb sowie eine Steuerung benötigt werden, welche beide Transportspuren gemeinsam zur Verfügung stehen.

In einer Ausgestaltung des Verfahrens nach Anspruch 8 bestücken die Bestückköpfe entweder die Substrate der in Transportrichtung jeweils linken Transportspuren oder die Substrate der in Transportrichtung jeweils rechten Transportspuren des ersten bzw. zweiten Spurenpaares gleichzeitig mit Bauelementen.

Bei der gleichzeitigen Bestückung sind die Bestückköpfe hinsichtlich ihrer Arbeitsfolge zeitlich aufeinander abgestimmt. Vorzugsweise werden hierfür auf allen Transportspuren gleichzeitig Substrate bereitgestellt. Der Bestückautomat weist hierzu eine Steuereinrichtung auf, welche die zeitlichen Bewegungsabläufe der Bestückköpfe derart steuert, dass ein gleichzeitiges Bestücken ermöglicht wird. Unter dem Begriff gleichzeitig ist dabei zu verstehen, dass mittels der Bestückköpfe die Bearbeitungsfolge
- Bauelemente abholen,
- Bauelemente in den Bestückbereich transferieren sowie
- Bauelemente auf dem jeweiligen Substrat positionieren, aufeinander abgestimmt erfolgt. Die Bearbeitungsfolge wird demnach gleichzeitig bzw. annähernd gleichzeitig ausgeführt. Die Bestückreihenfolge der Bauelemente auf dem jeweiligen Substrat ist dabei unerheblich. Durch diesen Bestückmodus kann eine gegenseitige Beeinflussung der jeweiligen Bestückköpfe und damit der Portale weitestgehend vermieden werden.

Um Wartezeiten eines Bestückkopfs zu vermeiden ist es sinnvoll, identisch zu bestückende Substrate für die Bestückköpfe im Bestückbereich des Bestückautoamten zu positionieren. Vorteilhafterweise werden für eine derartige aufeinander abgestimmte Bestückung auch identische Bestückköpfe verwendet, um die Taktzeiten der Bestückköpfe besser aneinander angleichen zu können.

Einen möglichen Sonderfall stellt hierbei die synchrone Bestückung dar, bei der die die Bestückköpfe identisch mit Bauelementen gerüstet sind. Dabei werden diese gleichzeitig oder annähernd gleichzeitig auf ihre jeweiligen Bestückpositionen auf den Substraten abgesetzt.

Im Folgenden wird die Transportvorrichtung anhand von Ausführungsbeispielen unter Bezug auf die beigefügten Figuren näher erläutert. In den Figuren sind:
- Figur 1: eine schematische Darstellung eines Bestückautomaten im Grundriss,
- Figur 2: eine schematische Darstellung der Transportvorrichtung im Aufriss.
- Figur 3: eine weitere schematische Darstellung der Transportvorrichtung im Grundriss

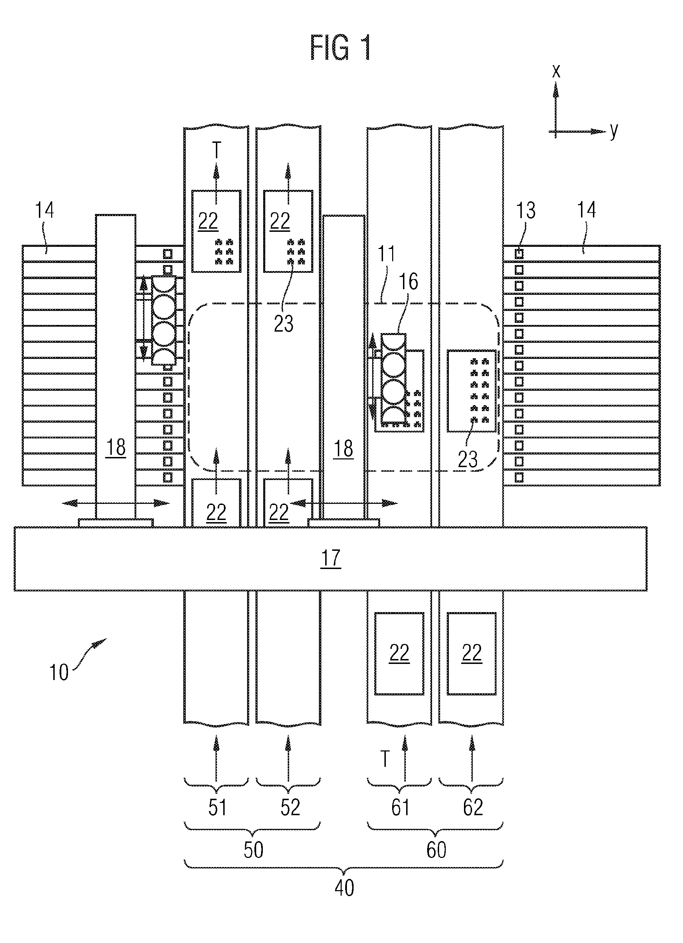

Figur 1 zeigt schematisch einen Bestückautomaten 10 zum Bestücken von Substraten 22 mit Bauelementen 23 in einer Draufsicht. Der Bestückautomat 10 besteht aus einem Querträger 17, welcher sich in einer y-Richtung erstreckt und fest mit einem Maschinengestell (nicht dargestellt) verbunden ist. Am Querträger 17 sind zwei Portalarme 18 angebracht, welche sich in x-Richtung erstrecken und in y-Richtung verschiebbar am Querträger 17 befestigt sind. Jeder der Portalarme 18 bildet zusammen mit dem Querträger 17 eine Positioniervorrichtung für jeweils einen der Bestückköpfe 16, wobei durch die x-Achse und die y-Achse jeweils ein orthogonales Bezugsystem gebildet wird. An jedem Portalarm 18 ist ein Bestückkopf 16 in x-Richtung verschiebbar angebracht. Weiterhin ist eine Transportvorrichtung 40 zum Transport der Substrate 22 vorgesehen. Mittels der Transportvorrichtung 40 können die Substrate 22 in x-Richtung in dem Bestückbereich 11 des Bestückautomaten 10 transportiert werden. Seitlich der Transportvorrichtung 40 sind in der Nähe des Bestückbereichs 11 Zuführvorrichtungen 14 angeordnet, welche die elektrischen Bauelemente 23 an Abholpositionen 13 bereitstellen. Die von den Zuführvorrichtungen 14 bereitgestellten Bauelemente 23 werden jeweils durch einen der Bestückköpfe 16 abgeholt und auf einem im Bestückbereich 11 positionierten Substrat 22 abgesetzt. Fertig bestückte Substrate 22 werden mit Hilfe der Transportvorrichtung 40 wieder aus dem Bestückbereich 11 heraus transportiert.

Die Transportvorrichtung 40 ist in Figur 1 vierspurig ausgeführt. Dabei bilden eine erste Transportspur 51 und eine zweite Transportspur 52, welche nebeneinander angeordnet sind, ein erstes Spurenpaar 50, in Figur 1 links dargestellt. Eine weitere erste und zweite Transportspur 61 und 62 bilden ein zweites Spurenpaar 60, in Figur 1 rechts dargestellt. Vorzugsweise sind die ersten und zweiten Transportspuren (51, 61 und 52, 62) sowie die beiden Spurenpaare (50, 60) jeweils parallel zueinander angeordnet. Die beiden Transportspuren (51, 52 bzw. 61, 62) eines jeden Spurenpaares 50 bzw. 60 werden dabei synchron betrieben, d. h. zwei identisch zu bestückende Substrate 22 werden gemeinsam mittels der beiden Transportspuren (51, 52 bzw. 61, 62) eines der Spurenpaare 50 bzw. 60 in einem Bestückbereich 11 des Bestückautomaten 10 bereitgestellt. Die beiden Spurenpaare 50 und 60 können dabei sowohl im synchronen Modus als auch im asynchronen Modus betrieben werden. Ein Betrieb im synchronen Modus hat zur Folge, dass vier Substrate 22 gemeinsam im Bestückbereich 11 bereitgestellt werden können.

Im asynchronen Modus werden mit Hilfe eines der beiden Spurenpaare (50 oder 60) Substrate 22 im Bestückbereich 11 positioniert und können mittels eines Bestückkopfes 16 bestückt werden. Mit Hilfe des anderen Spurenpaares (60 oder 50) werden währenddessen Substrate 22 in den Bestückbereich 11 hinein transportiert und/oder aus diesem herausgefahren. Da jeweils einer der Bestückköpfe 16 einem der Spurenpaare 50 bzw. 60 eindeutig zugeordnet ist, hat der asynchrone Betriebsmodus der Transportvorrichtung 40 zur Folge, dass auch die beiden Bestückköpfe 16 asynchron betrieben werden. Während einer der Bestückköpfe 16 Bauelemente 23 von den Abholpositionen 13 der Zuführeinrichtungen 14 abholt, ist es vorteilhaft, dass der andere Bestückkopf 16 das zur Mitte der Transportvorrichtung hin angeordnete Substrat 22 mit denjenigen Bauelementen 23 bestückt, die sich in einem Randbereich mit dem kürzesten Abstand zum jeweils anderen Spurenpaar 50 oder 60 ergeben. Selbst wenn der betreffende Portalarm 18 hierzu über die Mittellage des Querträgers 17 hinaus verfahren müsste, behindern sich dabei die beiden Portalarme bzw. die beiden Bestückköpfe nicht.

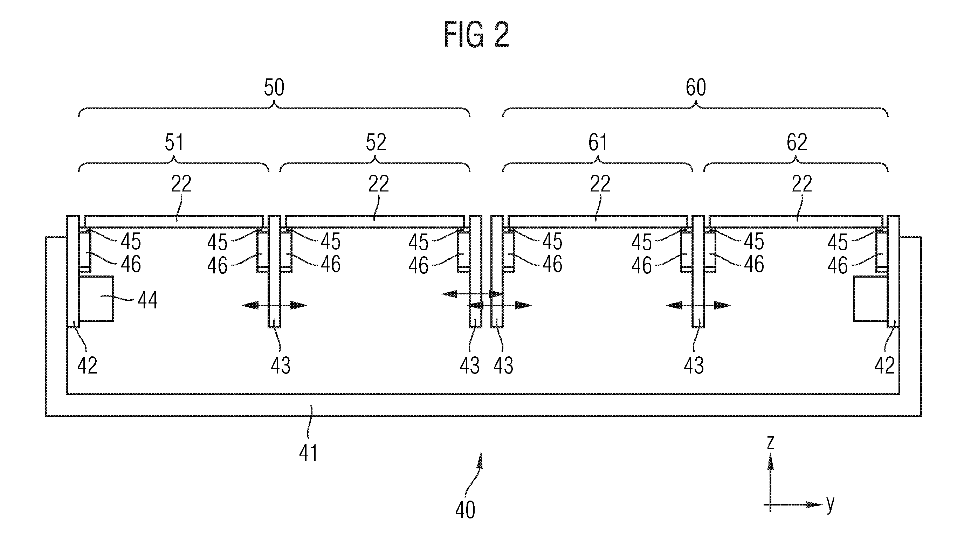

In Figur 2 ist mit Bezug auf Figur 1 die Transportvorrichtung 40 zum Transport von Substraten 22 im Aufriss dargestellt. Sie ist vierspurig ausgeführt und weist ein erstes Spurenpaar 50 und ein zweites Spurenpaar 60 auf, welche in einem Rahmen 41 der Transportvorrichtung 40 nebeneinander liegend angeordnet sind. Das erste Spurenpaar 50 weist eine erste Transportspur 51 und eine zweite Transportspur 52 auf, welche ebenfalls nebeneinander liegen. Das zweite Spurenpaar 60 weist eine erste Transportspur 61 sowie eine zweite Transportspur 62 auf, welche ebenfalls nebeneinander liegen. Vorteilhafter Weise sind die ersten und zweiten Transportspuren (51, 61 und 52, 62) sowie die beiden Spurenpaare (50, 60) jeweils parallel zueinander angeordnet. Die Substrate 22 liegen in ihren seitlichen Randbereichen auf Transportriemen 45 auf, welche über Umlenkrollen 46 geführt und angetrieben werden. Die Umlenkrollen 46 sind in einer definierten Höhenlage an Transportwangen 42 bzw. 43 seitlich befestigt. Zum Antrieb der Umlenkrollen 46 bzw. der Transportriemen 45 sind Antriebe 44 vorgesehen, welche mit zumindest einer der Umlenkrollen 46 gekoppelt sind. Für jedes Spurenpaar 50 bzw. 60 ist dabei ein eigener Antrieb 44 vorgesehen. Die Transportwangen 42 bzw. 43 können sowohl ortsfest als auch verschiebbar ausgebildet sein. In den Randbereichen der Transportvorrichtung 40 sind feste Transportwangen 42 vorgesehen, welche mit dem Rahmen 41 fest verbunden sind. Die weiteren Transportwangen sind als verschiebliche Transportwangen 43 ausgebildet, wodurch sich die Spurbreite einer jeden Transportspur 51, 52, 61, 62 exakt auf die Breite des zu transportierenden Substrats 22 einstellen lässt.

Mittels der verstellbaren Transportwangen 43 ist es ebenso möglich, Substrate unterschiedlichen Typs gleichzeitig im Bestückbereich 11 bereitzustellen.

Durch die Ausbildung fester Transportwangen 42 an den Randbereichen der Transportvorrichtung 40 ergibt sich der Vorteil, dass die Transportspuren 51, 52, 61, 62 möglichst nahe an den Zuführeinrichtungen 14 (siehe Figur 1) angeordnet sind. Die Verfahrwege der Bestückköpfe 16 (siehe Figur 1) zwischen den Zuführeinrichtungen 14 und dem Bestückbereich 11 (siehe Figur 1) können hierdurch reduziert werden, was die Bestückleistung des Bestückautomaten 10 erhöht.

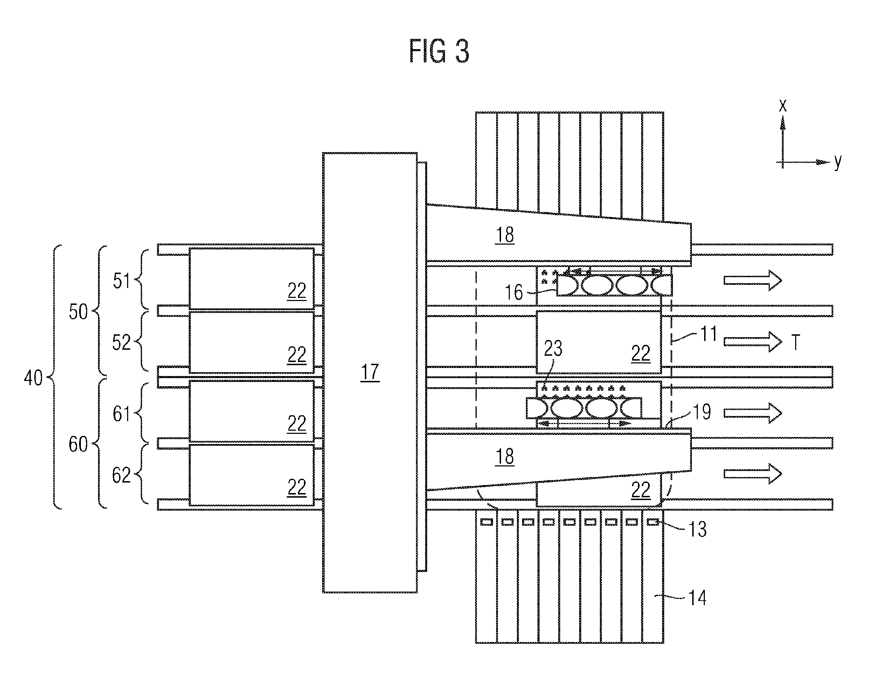

Figur 3 zeigt eine weitere schematische Darstellung der Transportvorrichtung 40 im Grundriss. Die Transportvorrichtung 40 besteht dabei wiederum aus einem ersten Spurenpaar 50 mit einer ersten Transportspur 51 und einer zweiten Transportspur 52, sowie einem zweiten Spurenpaar 60 mit einer ersten Transportspur 61 und einer zweiten Transportspur 62. Die beiden Spurenpaare 50 und 60 sowie die vier Transportspuren 51, 52, 61 und 62 sind parallel nebeneinander angeordnet, so dass sie Substrate 22 in einer y-Richtung transportieren können. Die Transportvorrichtung 40 wird von einem Querträger 17 in einer x-Richtung, welche senkrecht zur y- oder Transportrichtung T der Substrate 22 orientiert ist, überspannt. Am Querträger 17 sind zwei Portalarme 18 in x-Richtung verschiebbar befestigt. An jedem der beiden Portalarme 18 befindet sich ein Bestückkopf 16, welche in y-Richtung verschiebbar am jeweiligen Portalarm 18 angebracht sind. Die Bestückköpfe 16 sind dabei nicht jeweils auf der gleichen Seite des zugeordneten Portalarmes 18 angebracht, sondern einander zugewandt. Durch diese spiegelbildliche Anordnung der Portalarme 18 bzw. der Bestückköpfe 16 können die beiden Bestückköpfe 16 enger aneinander verfahren werden, ohne sich dabei gegenseitig zu behindern. Dies ist insbesondere dann von Vorteil, wenn die beiden mittleren Substrate 22, welche auf den Transportspuren 52 und 61 bereitgestellt werden, gleichzeitig mittels der beiden Bestückköpfe 16 bestückt werden. Jedem der Bestückköpfe 16 sind dabei die Substrate 22 eines der Spurenpaare 50 oder 60 eindeutig zugeordnet. Weiterhin sind jedem Bestückkopf 16 eigene Zuführeinrichtungen 14 zugeordnet, welche seitlich der Transportvorrichtung 40 auf Höhe des Bestückbereichs 11 angeordnet sind und an ihren Abholpositionen 13 Bauelemente 23 zur Abholung durch den Bestückkopf 16 bereitstellen.

Anhand von Figur 3 wird im Folgenden das Verfahren zum Bestücken von Substraten 22 mit Bauelementen 23 näher erläutert:

Die beiden Transportspuren 51 und 52 des ersten Spurenpaares 50 sowie die beiden Transportspuren 61 und 62 des zweiten Spurenpaares 60 werden jeweils derart betrieben, dass mittels der beiden Transportspuren des einen oder des anderen Spurenpaares 50, 60 immer zwei Substrate 22 eines Spurenpaares gleichzeitig im Bestückbereich 11 des Bestückautomaten 10 bereitgestellt werden.

Vorteilhafterweise werden auf allen Transportspuren 51, 52, 61, 62 Substrate 22 gleichzeitig bereitgestellt.

Anschließend erfolgt die Bestückung der bereitgestellten Substrate 22 mit Bauelementen 23. Dabei werden mittels der Bestückköpfe 16 entweder die Substrate 22 der in Transportrichtung T jeweils linken Transportspuren 51 oder 61, oder die Substrate 22 der in Transportrichtung T jeweils rechten Transportspuren 52, 62 des ersten bzw. zweiten Spurenpaares 50, 60 gleichzeitig mit Bauelementen 23 bestückt.

Jeder der Bestückköpfe 16 ist dabei einem der Spurenpaare 50, 60 eindeutig zugeordnet und bestückt nur Substrate 22, welche mittels der Transportspuren dieses einen Spurenpaares 50 bzw. 60 transportiert und bereitgestellt werden.

Unter dem Begriff "gleichzeitig" ist dabei zu verstehen, dass die Bearbeitungsreihenfolge Bauelemente 23 abholen, Bauelemente 23 in den Bestückbereich 11 transferieren, sowie Bauelemente 23 auf dem jeweiligen Substrat 22 positionieren, der Bestückköpfe 16 aufeinander abgestimmt, d.h. gleichzeitig oder annähernd gleichzeitig ausgeführt wird. Die Bestückreihenfolge der Bauelemente 23 auf dem jeweiligen Substrat 22 ist dabei unerheblich.

Der Vorteil dieses Bestückverfahrens ergibt sich daraus, dass sich die Bestückköpfe 16 - insbesondere beim Bestücken der Randbereiche kleinerer Substrate 22 - nicht gegenseitig beeinflussen oder gar behindern. Wartezeiten eines Bestückkopfes 16 werden somit vermieden, die Flexibilität wird dadurch erhöht. Die reale Bestückleistung des Bestückautomaten 10 wird deutlich gesteigert.

### Bezugszeichenliste:

- 10: Bestückautomat
- 11: Bestückbereich
- 13: Abholposition
- 14: Zuführeinrichtung
- 15: Führungselement
- 16: Bestückkopf
- 17: Querträger
- 18: Portalarm
- 22: Substrat
- 23: Bauelement
- 40: Transportvorrichtung
- 41: Rahmen
- 42: feste Transportwange
- 43: verschiebbare Transportwange
- 44: Antrieb
- 45: Transportriemen
- 46: Umlenkrolle
- 50: Erstes Spurenpaar
- 51: Erste Transportspur
- 52: Zweite Transportspur
- 60: Zweites Spurenpaar
- 61: Erste Transportspur
- 62: Zweite Transportspur

## Patentansprüche

1. Transportvorrichtung (40) zum Transportieren von Substraten (22) in einen Bestückbereich (11) eines Bestückautomaten (10) zum Bestücken der Substrate (22) mit Bauelementen (23), wobei die Transportvorrichtung (40) mindestens ein erstes und ein zweites Spurenpaar (50, 60) aufweist, wobei die Spurenpaare (50, 60) nebeneinander angeordnet sind und jedes Spurenpaar (50, 60) aus zwei einzelnen, nebeneinander liegenden ersten und zweiten Transportspuren (51, 52, 61, 62) besteht.

2. Transportvorrichtung (40) nach Anspruch 1, wobei die beiden nebeneinander liegenden Transportspuren (51, 52, 61, 62) eines jeden Spurenpaares (50, 60) synchron antreibbar sind und die mindestens zwei Spurenpaare (50, 60) entweder synchron oder sowohl synchron als auch asynchron betrieben werden können.

3. Transportvorrichtung (4) nach einem der Ansprüche 1 bis 2, wobei die einzelnen Transportspuren (51, 52, 61, 62) auf die Breite der zu transportierenden Substrate (22) individuell einstellbar sind.

4. Bestückautomat (10) zum Bestücken von Substraten (22) mit Bauelementen (23), mit einer Transportvorrichtung (40) nach einem der Ansprüche 1 bis 3.

5. Bestückautomat (1) nach Anspruch 4, wobei der Bestückautomat (10) mehrere Bestückköpfe (16) zum Bestücken der Substrate (22) aufweist, und jedem Bestückkopf (16) eines der Spurenpaare (50, 60) eindeutig zugeordnet ist, so dass mittels dieses Bestückkopfs (16) nur Substrate (22) dieses einen Spurenpaares (50, 60) bestückbar sind.

6. Bestückautomat (10) nach einem der Ansprüche 4 oder 5, mit
- einem Querträger (17), welcher die Transportvorrichtung (4) überspannt und sich quer zu einer Transportrichtung (T) der Substrate (22) erstreckt, zum Anbringen mindestens eines Portalarms (18),
- zwei Portalarmen (18), welche sich in Transportrichtung (T) erstrecken und nebeneinander auf derselben Seite des Querträgers (17) verschieblich angeordnet sind,
- zwei Bestückköpfen (16), welche jeweils an einem der Portalarme (18) angeordnet sind,
bei dem die beiden Bestückköpfe (16) einander zugewandt sind.

7. Verfahren zum Bestücken von Substraten (22) mit Bauelementen (23) mit einem Bestückautomaten (10) nach einem der Ansprüche 4 bis 6,
wobei die beiden Transportspuren (51, 52) des ersten Spurenpaars (50) sowie die beiden Transportspuren (61, 62) des zweiten Spurenpaars (60) jeweils derart betrieben werden, dass mittels eines Spurenpaares (50, 60) immer zwei Substrate (22) gleichzeitig im Bestückbereich (11) bereitgestellt werden.

8. Verfahren nach Anspruch 7,
wobei die Bestückköpfe (16) entweder die Substrate (22) der in Transportrichtung (T) jeweils linken Transportspuren (51, 61) oder die Substrate (22) der in Transportrichtung (T) jeweils rechten Transportspuren (52, 62) des ersten bzw. zweiten Spurenpaars (50, 60) gleichzeitig mit Bauelementen (23) bestücken.
